# EUROPEAN PATENT SPECIFICATION

(11) **EP 2 840 656 B1**
(45) Date of publication and mention of the grant of the patent: **08.08.2018**
(21) Application number: 12866399.4
(22) Date of filing: 06.12.2012
(51) Int. Cl.: H01R 4/04, H05K 1/18, H05K 3/36, H05K 7/02, H05K 3/32, G02F 1/1345

(54) **CONNECTING DEVICE, FLAT PANEL DEVICE, IMAGE SENSOR, DISPLAY AND TOUCH DEVICE**
VERBINDUNGSVORRICHTUNG, FLACHTAFELVORRICHTUNG, BILDSENSOR, ANZEIGE UND BERÜHRUNGSVORRICHTUNG
DISPOSITIF DE CONNEXION, DISPOSITIF À PANNEAU PLAT, CAPTEUR D'IMAGE, DISPOSITIF D'AFFICHAGE ET DISPOSITIF TACTILE

(30) Priority: 13.04.2012 CN 201210109807
(43) Date of publication of application: 25.02.2015
(73) Proprietor: Shanghai Tianma Micro-electronics Co., Ltd., Pudong New District Shanghai 201201 (CN)
(72) Inventor: LING, Yan, Shanghai 201201 (CN)
(74) Representative: Maiwald Patent- und Rechtsanwaltsgesellschaft mbH
(86) International application number: PCT/CN2012/086037
(87) International publication number: WO 2013/152598

(56) References cited:
- EP-A2- 1 085 788
- WO-A1-2011/161857
- CN-A- 1 108 859
- CN-A- 1 818 747
- CN-A- 1 818 747
- CN-A- 1 984 524
- CN-A- 1 984 524
- JP-A- H05 188 389
- US-A- 5 130 833
- US-A- 5 130 833
- US-A1- 2002 140 654
- US-A1- 2005 088 830

## Description

### FIELD OF THE INVENTION

The present invention relates to electronic technologies, and in particular to a connecting device, a flat panel device, an image sensor, a display and a touch apparatus.

### BACKGROUND OF THE INVENTION

X-ray flat panel detector is large-area planar X-ray imaging equipment. The X-ray passing through an irradiated object is converted into an electronic signal by the X-ray flat panel detector, and then a digitized gray scale image directly relating to the internal structure of the irradiated object is formed. By using the X-ray flat panel detector, the non-destructive internal imaging of the object can be realized, which is one of the most preferable ways to realize the non-destructive inspection. The X-ray flat panel detector has achieved a wide-spread application and great progress in the fields of medical imaging, industrial nondestructive detection and so on.

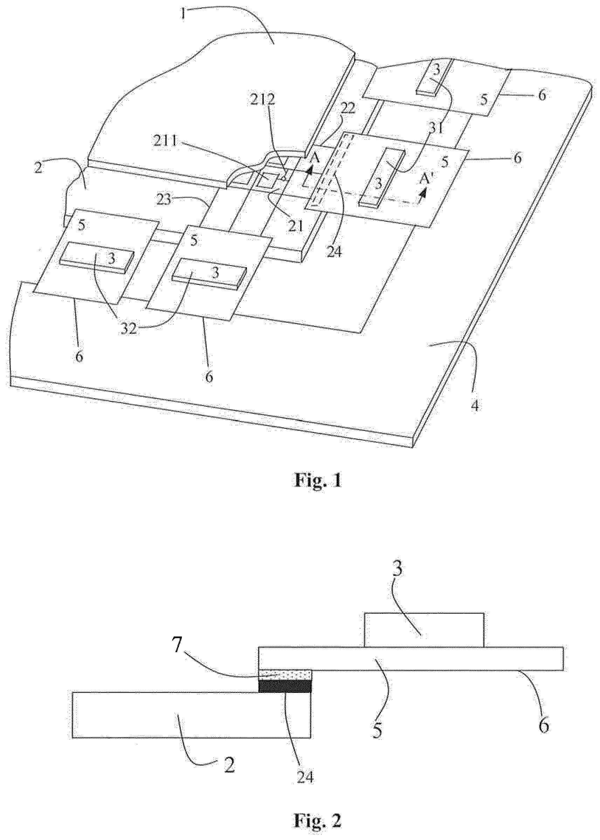

As illustrated in FIG. 1, the X-ray flat panel detector includes an X-ray fluorescent layer 1, a flat panel sensor 2, image acquisition chips 3 and a peripheral logic control and image processing system 4. Specifically, the image acquisition chip 3 includes a switch control chip 31 and a signal read-out chip 32. The flat panel sensor 2 used in the X-ray flat panel detector illustrated in FIG. 1 is an indirect flat panel sensor which only absorbs the visible light and the light with wavelength close to that of the visible light. Thus the X-ray fluorescent layer 1 needs to convert the X-ray into the visible light such as green light or blue light. In an another X-ray flat panel detector, the flat panel sensor 2 used is a direct flat panel sensor which can absorb the X-rays directly and in this case, the X-ray fluorescent layer 1 may not be needed.

The flat panel sensor 2 includes a large pixels array and a transparent substrate. The pixels array is one of the core components in the whole X-ray flat panel detector and is disposed on the transparent substrate (e.g., a glass substrate, a quartz substrate). The pixels array includes a plurality of control lines 22 extending along the X axis direction and a plurality of read lines 23 extending along the Y axis direction, the X axis and the Y axis being substantially perpendicular to each other. The region surrounded by two adjacent control lines 22 and two adjacent read lines 23 is a pixel region, in which a pixel unit is disposed. Each pixel unit 21 includes a photosensor 211(e.g., a photodiode) and at least one switching element 212(e.g., a thin film transistor, TFT). The state of the switching element 212 is controlled by a control signal on the control line 22. When the switching element 212 is turned on, the signal in the pixel unit 21 which in the same pixel region as the switching element 212 can be read by the read line 23; and when the switching element 212 is turned off, the signal in the pixel unit 21 which in the same pixel region as the switching element 212 can not be read by the read line 23. Specifically, in a case where the switching element 212 is a TFT, for example, the TFT is disposed at the intersection between one control line 22 and one read line 23, and the pixel unit 21 which in the same pixel region as the TFT is coupled to the control line 22 and the read line 23 via the TFT. The coupling means that a gate electrode of the TFT is electrically connected to the control line 22, a source electrode/drain electrode of the TFT is electrically connected to the read line 23, and a drain electrode/source electrode of the TFT is electrically connected to the pixel unit 21. The size and number of the pixel units 21 may reflect the resolution and the area of the image.

The X-rays passing through the object under detection could be converted into visible light by the X-ray fluorescent layer 1, and the visible light are projected onto (or the X-rays passing through the irradiated object are directly projected onto) the photosensors 211 of the flat panel sensor 2. The photosensors 211 generate electric charges in a corresponding proportion and temporarily store them in the pixel units 21 of the flat panel sensor 2. When a control signal is applied to one control line 22 and the switching element TFT 212 of which the gate electrode is electrically connected to the control line 22 is turned on, the electric charge signal temporarily stored in the photosensor 211 could be read out by the read line 23 which is electrically connected to the source/drain electrode of the switching element TFT 212, and then an analog-to-digital conversion or another corresponding processing is performed on the electric charge signal.

The peripheral logic control and image processing system 4 controls the image acquisition chips 3 to function properly, so as to turn the switching element TFTs 212 in each row of the pixel units 21 on or off and to read and process the charge signals in the photosensors 211 in respective pixel units 21. The switch control chips 31 sequentially turns on the switching element TFTs 212 line by line via the control lines 22.While the switching element TFTs 212 are turned on, the signal read-out chips 32 read out the charge signals temporarily stored in the pixel units 21 via the read lines 23, perform the analog-to-digital conversion, and transmit the processed digital signals to the peripheral logic control and image processing system 4. In this way, the image acquisition is performed line by line until all of the charge signals in the pixel units 21 of the whole flat panel sensor 2 are read out, so that the complete image is read and processed.

As illustrated in FIG. 2, in the prior art, the image acquisition chip 3 is packaged on a flexible printed circuit board (FPC) 5 by a chip on film (COF) bonding process. The image acquisition chip 3 and the FPC 5, which are packaged together, form a COF module 6. Then the COF module 6 is bonded onto a conductive contact 24 of the flat panel sensor 2 by a film on glass (FOG) bonding process, so that the flat panel sensor 2 and the image acquisition chip 3 are in electrical connection and in conductive connection. In the FOG bonding, the conductive contact 24 of the flat panel sensor 2 is coated with an anisotropic conductive film (ACF) 7, then the FPC 5 of the COF module 6 is connected to the conductive contact 24 of the flat panel sensor 2 by heat pressing. The ACF 7 can realize conduction in the vertical direction but non-conduction in the horizontal direction. Thereby, the COF module 6 is in conductive connection to the conductive contact 24 but insulating the adjacent conductive contact(s). Certainly, in the prior art, the COF module 6 may also be metal-welded to the conductive contact 24 of the flat panel sensor 2, so that the flat panel sensor 2 and the image acquisition chip 3 are in electrical connection and conductive connection.

In use or test, if the flat panel sensor 2 has a problem, for example, its performance is unqualified, and the COF module 6 should be removed from the flat panel sensor 2, the FPC 5 in the COF module 6 could be damaged in the removing process, due to the sticking and heat pressing process or the metal-welding process of the ACF 7 and the flexible feature of the FPC 5, causing that the whole COF module 6 can not function. However, the image acquisition chip 3 in the COF module, although not damaged, can not be recycled because the FPC 5 is damaged, resulting in extremely waste.

In fact, not only in the case of the X-ray flat panel detector, the image acquisition chip 3 can not be recycled, resulting in waste, as described above; but also in the case of other apparatuses, (e.g., touch screens, flat panel displays) where the chip unit and the flexible connecting device are packaged as the COF module which is then connected to the substrate unit of the apparatus by ACF bonding or metal-welding, the chip can not be recycled due to the damage of the flexible connecting device in the COF module in the separation process, resulting in extremely waste.

CN 1984524 A discloses a flexible circuit film whose signal lines are resistant to cracking even upon bending is presented. The flexible circuit film includes a base substrate, a signal transmission line and a crack-preventing portion. The signal transmission line is formed on a first surface of the base substrate. The crack-preventing portion is formed on a portion of a second surface of the base substrate that is opposite to the first surface to prevent cracking of the signal transmission line. The crack-preventing portion is formed on the part of the flexible circuit film that is bent by a large angle when the flexible circuit film is assembled with another component.

CN 1818747 A relates to a display apparatus, wherein a printed circuit board has a base substrate, a flip chip, and an adhesive member. The flip chip is mounted onto a first face of the base substrate by the adhesive member between the flip chip and the first face of the base substrate. The first display panel is disposed on a second face opposite to the first face of the base substrate, and a second display panel is mounted on the first face of the base substrate with the flip chip. Thus, a chip mounted on the printed circuit board is made smaller and the freed up space can be used to mount the second display panel.

US 5130833 A relates to a liquid crystal device and a manufacturing method thereof are described. The device comprises a liquid crystal panel and an auxiliary panel formed with an IC circuit for supplying driving signals to the liquid crystal device. The auxiliary substrate is separately provided with the circuit and the function thereof is tested in advance of the assembling with the liquid crystal panel.

US 2005/088830 A1 relates to a liquid crystal display device includes a liquid crystal display panel having a first substrate and a second substrate opposed thereto arranged so that the inner surfaces thereof oppose each other with an intermediate sealing member and a liquid crystal interposed in the internal space, and a flexible printed circuit board having an input/output terminals connected thereto. A circuit board on which a plurality of electronic components required for operating the liquid crystal display apparatus are mounted on the flexible printed circuit board.

US 2002/140654 A1 relates to a liquid crystal display of compact size is disclosed. The liquid crystal display has a signal transmission film and a single integrated PCB for processing a gate driving signal and data driving signal. The signal transmission film includes a base substrate, a gate driver IC formed on said base substrate, an input pattern formed on said base substrate that applies gate driving signals input from an external device to the gate driver IC, a first output pattern formed on said base substrate that outputs a first gate driving signal processed in said gate driver IC, and a second output pattern formed on said base substrate, that outputs a second gate driving signal bypassing the gate driver IC among the gate driving signals.

EP 1085788 A2 relates to a composite flexible wiring board 100 comprises a first flexible wiring board 10 and a second flexible wiring board 30 on which a surface-mounted part 44 is provided. The second flexible wiring board 30 is disposed on the first flexible wiring board 10 in its predetermined area. The first flexible wiring board 10 and the second flexible wiring board 30 are electrically connected to each other through an interlayer contact portion 50 provided in a predetermined position. The first flexible wiring board 10 has an input terminal region 11A and an output terminal region 11B with a power IC chip 18 mounted on the first flexible wiring board. There is thus provided a composite flexible wiring board including surface-mounted parts and being able to constitute a hybrid IC, a method of manufacturing the composite flexible wiring board, an electro-optical device, and electronic equipment.

WO 2011/161857 A1 relates to a display device 100 wherein a row of protruding electrodes 115 and a row of protruding electrodes 116 are formed on the connecting surface of a terminal section 112, and the row of the protruding electrodes 116 is disposed at a position closer to the display section 111 than the row of the protruding electrodes 115. One end portion of a flexible printed board 150 is connected to the row of the protruding electrodes 115, and one end portion of a flexible printed board 160 is connected to the row of the protruding electrodes 116. The row of the protruding electrodes 115 is adjacent to the row of the protruding electrodes 116, and said end portion of the flexible printed board 150 and said end portion of the flexible printed board 160 are facing each other.

### SUMMARY OF THE INVENTION

A detailed description is given in the following embodiments with reference to the accompanying drawings.

To solve the above-mentioned technical problem, a connecting device for connecting a substrate unit and a chip unit is disposed according to an embodiment of the present invention. The connecting device includes: a first flexible connection unit, including a first wire for electrically connecting to the substrate unit; a rigid connection unit, connected to the first flexible connection unit and including a second wire for connecting to the first wire; the chip unit is electrically connected to the second wire. A first conductive contact terminal and a second conductive contact terminal are disposed on two ends of the first wire of the first flexible connection unit, respectively; a third conductive contact terminal is disposed on one end of the second wire of the rigid connection unit; the first conductive contact terminal is used for connecting to the substrate unit by anisotropic conductive film bonding or metal-welding; and the second conductive contact terminal and the third conductive contact terminal are connected by anisotropic conductive film bonding or metal-welding. The rigid connection unit further includes a rigid substrate; a fourth conductive contact terminal is disposed on the other end of the second wire of the rigid connection unit; and the second wire, the third conductive contact terminal and the fourth conductive contact terminal are disposed on the rigid substrate. The connecting device further includes a second flexible connection unit, wherein the second flexible connection unit includes a fifth conductive contact terminal, a sixth conductive contact terminal and a third wire connecting the fifth conductive contact terminal and sixth conductive contact terminal; the fourth conductive contact terminal and the fifth conductive contact terminal are connected by anisotropic conductive film bonding or metal-welding; the sixth conductive contact terminal is used for connecting to the chip unit by anisotropic conductive film bonding or metal-welding.

To solve the above-mentioned technical problem, a flat panel device is further provided according to an embodiment of the present invention, including: a substrate unit, a first flexible connection unit, a rigid connection unit and a chip unit. Specifically the first flexible connection unit is connected to the substrate unit and includes a first wire electrically connected to the substrate unit; the rigid connection unit is connected to the first flexible connection unit and includes a second wire electrically connected to the first wire; and the chip unit is electrically connected to the substrate unit via the second wire and the first wire in sequence. The substrate unit and the first flexible connection unit are connected by anisotropic conductive film bonding or metal-welding; and the first flexible connection unit and the rigid connection unit are connected by anisotropic conductive film bonding or metal-welding. The flat panel device further includes a second flexible connection unit, wherein the rigid connection unit and the second flexible connection unit are connected by anisotropic conductive film bonding or metal-welding.

A flat panel image sensor is provided according to an embodiment of the present invention, including the flat panel device, and the substrate unit includes a TFT array substrate, in the pixel region of the TFT array substrate, a plurality of photosensitive sensors are disposed.

An organic light-emitting diode display is further provided according to an embodiment of the present invention, including the flat panel device, and the substrate unit includes a TFT array substrate, in the pixel region of the TFT array substrate, a plurality of organic light-emitting diodes are disposed.

A liquid crystal display is further provided according to an embodiment of the present invention, including: a color film substrate, a liquid crystal layer, and the flat panel device; the substrate unit includes a TFT array substrate, in the pixel region of the TFT array substrate, a plurality of pixel electrodes are disposed; the color film substrate and the TFT array substrate are disposed opposite to each other, with the liquid crystal layer filling between the color film substrate and the TFT array substrate.

An electronic paper display is further provided according to an embodiment of the present invention, including: an upper substrate, a microcapsule layer and the flat panel device; the substrate unit includes a TFT array substrate; in the region of the TFT array substrate, a plurality of pixel electrodes are disposed; the upper substrate and the TFT array substrate are disposed opposite to each other, with the microcapsule layer filling between the upper substrate and the TFT array substrate.

A touch apparatus is further provided according to an embodiment of the present invention, including the flat panel device, and the substrate unit is the touch screen.

### BRIEF DESCRIPTION OF THE DRAWINGS

FIG. 1 is a schematic diagram of the three-dimensional structure of an existing X-ray flat panel detector;
FIG. 2 is a schematic cross-sectional diagram taken along the line A-A' of FIG. 1;
FIG. 3 is a schematic structure diagram of a connecting device according to a first embodiment of the present invention;
FIG. 4 and 5 are schematic diagrams of the three-dimensional structure of a flat panel devices according to the present invention;
FIG. 6 is a schematic structure diagram of a connecting device according to a second embodiment of the present invention;
FIG. 7 and 8 are schematic diagrams of the three-dimensional structure of another flat panel device according to the present invention;
FIG. 9 and 10 are schematic structure diagrams of a flat panel device according to a third embodiment of the present invention;
FIG. 11 and 12 are schematic structure diagrams of a flat panel device according to a fourth embodiment of the present invention;
FIG. 13 is a schematic diagram of the three-dimensional structure of a flat panel device according to a fifth embodiment of the present invention;
FIG. 14 is a cross-sectional schematic diagram taken along the line B-B' of FIG. 13;
FIG. 15 and 16 are schematic diagrams of the three-dimensional structure of a flat panel device according to a sixth embodiment of the present invention; and
FIG. 17 and 18 are schematic diagrams of the three-dimensional structure of a flat panel device according to a seventh embodiment of the present invention.

### DETAILED DESCRIPTION OF THE INVENTION

In the following, the specific embodiments of the present invention will be described in detail in conjunction with the drawings. The invention is described in more details in the following paragraphs with reference to the drawings by way of examples. The advantages and characteristics of the invention will be clearer from the following illustration.

It should be noted that, the ACF bonding technology is well known to the skilled in the art and will not be described in details herein. In brief, the essential of the ACF bonding technology is to dispose an ACF (anisotropic conductive film) between the conductive contacts of two units and then to perform the heat pressing so that the conductive contacts of the two units are conductive in the vertical direction but not conductive in the horizontal direction. Thus, such a connection of two units is referred as "being connected by ACF bonding" herein. For example, the bonding in which the chip is connected to the glass substrate by ACF bonding is known as COG bonding; the bonding in which the chip is connected to the FPC by ACF bonding is known as COF bonding; the bonding in which the chip is connected to the PCB substrate by ACF bonding is known as COB bonding; the bonding in which the FPC is connected to the glass substrate by ACF bonding is known as FOG bonding; the bonding in which the FPC is connected to the FPC by ACF bonding is known as FOF bonding; the bonding in which the FPC is connected to the PCB substrate by ACF bonding is known as FOB bonding. In addition, the metal-welding technology is also well known in the art and will not be described in details herein. In brief, the essential of metal-welding is to apply high temperature or ultrasonic wave to conductive contacts of two units while the conductive contacts are pressed together, causing the conductive contacts of the two units to be melt under heating and fused with each other to form alloy, so as to realize both the electrical connection and the mechanical connection.

A connecting device for connecting a substrate unit and a chip unit is disposed according to an embodiment of the present invention. The connecting device includes: a first flexible connection unit, including a first wire for electrically connecting to the substrate unit; a rigid connection unit, connected to the first flexible connection unit and including a second wire for connecting to the first wire; the chip unit being electrically connected to the second wire. The chip unit may transmit a signal to the substrate unit via the second wire and the first wire in sequence. In the present invention, the term "in sequence" refers to that the signal provided by the chip unit passes through the second wire first and then passes through the first wire in the transmission path before finally reaching the substrate unit. Thus, the chip unit could be disposed in the rigid connection unit. Alternatively, the chip unit could be connected to an additional unit first and then be in indirect connection with the rigid connection unit by means of the additional unit.

The first wire could be made of metal or other conductor and could be of one layer or multiple layers.

The second wire could be made of metal or other conductor and could be of one layer or multiple layers.

The rigid connection unit could be connected to the first flexible connection unit in a one-to-one way, i.e., one rigid connection unit is connected to one first flexible connection unit. The rigid connection unit may also be connected to first flexible connection units in a one-to-many way, i.e., one rigid connection unit is connected to at least two first flexible connection units.

### First Embodiment

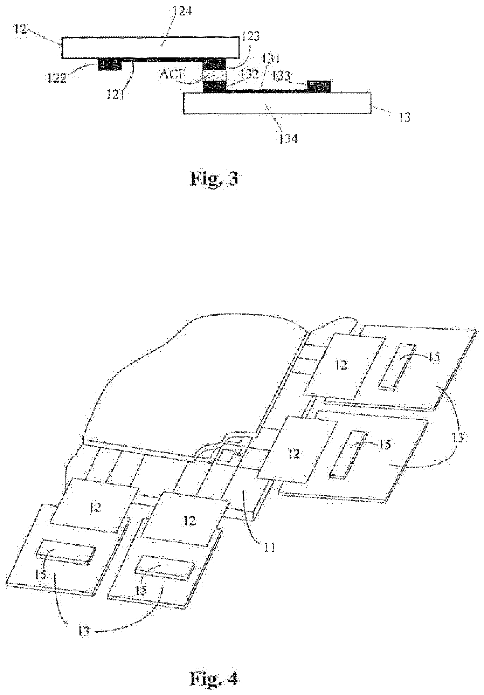

As illustrated in FIG. 3, the rigid connection unit 13 could be connected to the first flexible connection unit 12 by ACF bonding. That is to say, ACF is coated between the conductive contact terminal of the rigid connection unit 13 and the conductive contact terminal of the first flexible connection unit 12, and then heat pressing is performed, thereby the conductive contact terminal of the rigid connection unit 13 and the conductive contact terminal of the first flexible connection unit 12 being connected.

Specifically, a first conductive contact terminal 122 and a second conductive contact terminal 123 are disposed on two ends of the first wire 121 of the first flexible connection unit 12, respectively. A third conductive contact terminal 132 is disposed on one end of the second wire 131 of the rigid connection unit 13. The first conductive contact terminal 122 is used for connecting to the substrate unit by ACF bonding. The second conductive contact terminal 123 is connected to the third conductive contact terminal 132 by ACF bonding. The first wire 121 connects the corresponding first conductive contact terminal 122 and the second conductive contact terminal 123.

The first flexible connection unit 12 could be a FPC. The first flexible connection unit 12 may include a flexible substrate 124, and the first wire 121, the first conductive contact terminal 122 and the second conductive contact terminal 123 which are disposed on the flexible substrate 124. The first wire could be made of metal or other conductor and could be of one layer or multiple layers. The first wire 121 could be formed either on one surface of the first flexible substrate 124 or on two surfaces of the first flexible substrate 124. The portions of the first wire 121 formed on different layers of the same surface of the first flexible substrate 124 or on the different surfaces of the first flexible substrate 124 could be connected via hole(s).

The rigid connection unit 13 may include a rigid substrate 134. A fourth conductive contact terminal 133 is disposed on the other end of the second wire 131 of the rigid connection unit 13. The second wire 131, the third conductive contact terminal 132 and the fourth conductive contact terminal 133 are on the rigid substrate 134. The second wire 131 connects the corresponding third conductive contact terminal 132 and the fourth conductive contact terminal 133. The rigid substrate 134 could be made of glass, quartz, PCB or the like. The second wire could be made of metal or other conductor and could be of one layer or multilayer. The second wire 131 could be made either on one surface of the rigid substrate 134 or on two surfaces of the rigid substrate 134. The portions of the second wire 131 on the different layers of the same surface of the rigid substrate 134 or on the different surfaces of the rigid substrate 134 could be connected via hole(s).

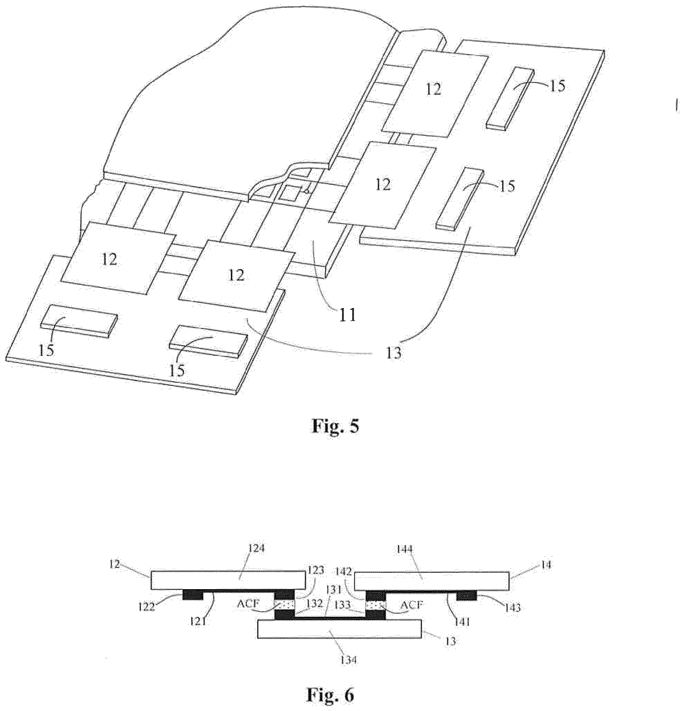

As illustrated in FIG. 4, the rigid connection unit 13 could be connected to the first flexible connection unit 12 in a one-to-one way, i.e., one rigid connection unit 13 is connected to one first flexible connection unit 12. As illustrated in FIG. 5, the rigid connection unit 13 could also be connected to first flexible connection units 12 in a one-to-many way, i.e., one rigid connection unit 13 is connected to at least two first flexible connection units 12.

The fourth conductive contact terminal 133 could be used for connecting to the chip unit by ACF bonding. The fourth conductive contact terminal 133 could also be used for connecting to other devices.

As another preferred embodiment, the way of "being connected by ACF bonding" according to the first embodiment could be replaced with the way of "being connected by metal-welding".

### Second Embodiment

As illustrated in FIG. 6, the connecting device further includes a second flexible connection unit 14. The second flexible connection unit 14 includes a fifth conductive contact terminal 142, a sixth conductive contact terminal 143 and a third wire 141 connecting the fifth conductive contact terminal 142 and the sixth conductive contact terminal 143. The fifth conductive contact terminal 142 and the fourth conductive contact terminal 133 are connected by ACF bonding.

The sixth conductive contact terminal 143 could be used for connecting to the chip unit by ACF bonding. The sixth conductive contact terminal 143 may also be used for connecting to other devices.

The flexible connection unit 14 could be a FPC. The flexible connection unit 14 may include a second flexible substrate 144, and the third wire 141 which is on the second flexible substrate 144, the fifth conductive contact terminal 142 and the sixth conductive contact terminal 143 which are on the second flexible substrate 144. The fifth conductive contact terminal 142 and the sixth conductive contact terminal 143 are disposed at the two ends of the third wire 141, and the third wire 141 connects the fifth conductive contact terminal 142 and the sixth conductive contact terminal 143. The third wire 141 could be made of metal or other conductor and could be of one layer or multilayer. The third wire 141 could be formed either on one surface of the second flexible substrate 144 or on two surfaces of the second flexible substrate 144. The portions of the third wire 141 on the different layers of the same surface of the second flexible substrate 144 or on the different surfaces of the second flexible substrate 144 could be connected via hole(s).

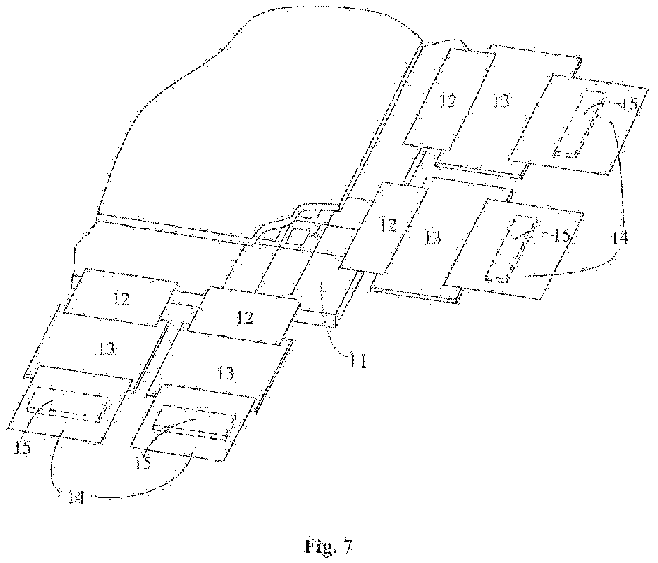

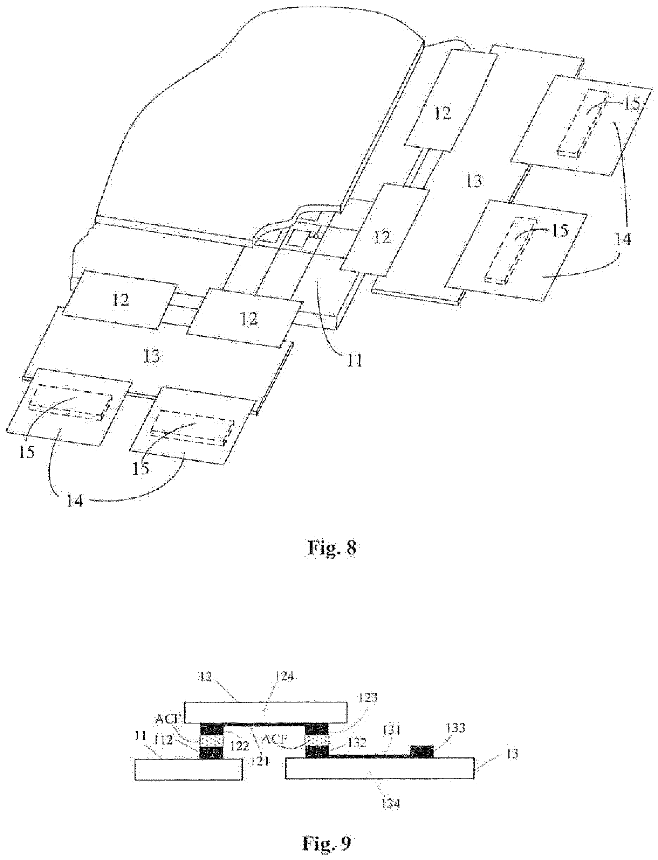

As illustrated in FIG. 7, the rigid connection unit 13 could be connected to the second flexible connection unit 14 in a one-to-one way, i.e., one rigid connection unit 13 is connected to one second flexible connection unit 14. As illustrated in FIG. 8, the rigid connection unit 13 could also be connected to the second flexible connection units 14 in a one-to-many way, i.e., one rigid connection unit 13 is connected to at least two second flexible connection units 14.

A flat panel device is further provided according to an embodiment of the present invention. The flat panel includes: a substrate unit, a first flexible connection unit, a rigid connection unit and a chip unit. The first flexible connection unit is connected to the substrate unit and includes a first wire electrically connected to the substrate unit. The rigid connection unit is connected to the first flexible connection unit and includes a second wire electrically connected to the first wire. The chip unit is electrically connected to the substrate unit via the second wire and the first wire in sequence.

The substrate unit could be connected to the first flexible connection unit by ACF bonding; the first flexible connection unit is connected to the rigid connection unit by ACF bonding. For the X-ray flat panel detector, the chip unit could be either a switch control chip or a signal read-out chip. For the flat panel display (such as LCD, OLED, E-BOOK), the chip unit could be either a scan-driving chip or a data-driving chip; or the chip unit could be either a scan-driving chip or a touch detection chip.

As another preferred embodiment, the way of "being connected by ACF bonding" according to the first embodiment could be replaced with the way of "being connected by metal-welding".

### Third Embodiment

As illustrated in FIG. 9, the substrate unit 11 includes a substrate conductive contact terminal 112; the first conductive contact terminal 122 and the second conductive contact terminal 123 are disposed on two ends of the first wire 121 of the first flexible connection unit 12, respectively; the third conductive contact terminal 132 and the fourth conductive contact terminal 133 are disposed on two ends of the second wire 131 of the rigid connection unit 13, respectively; the substrate conductive contact terminal 112 is connected to the first conductive contact terminal 122 by ACF bonding; and the second conductive contact terminal 123 is connected to the third conductive contact terminal 132 by ACF bonding.

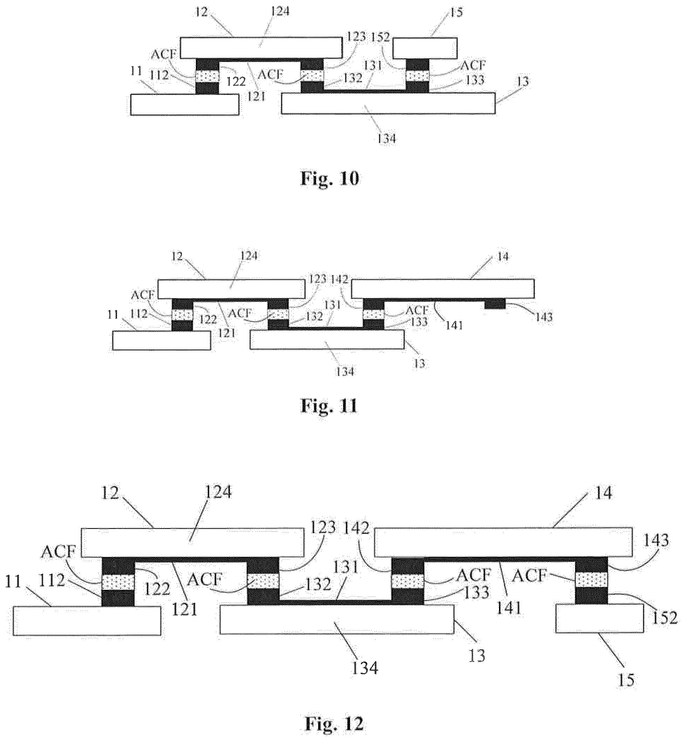

The rigid connection unit could be connected to the chip unit by ACF bonding. As illustrated in FIG. 10, the fourth conductive contact terminal 133 of the rigid connection unit 13 is connected to the chip unit 15 by ACF bonding. Specifically, the fourth conductive contact terminal 133 of the rigid connection unit 13 is connected to a chip conductive contact terminal 152 of the chip unit 15 by ACF bonding.

Still referring to FIG. 4, the rigid connection unit 13 could be connected to the first flexible connection unit 12 in a one-to-one way, i.e., one rigid connection unit 13 is connected to one first flexible connection unit 12. Still referring to FIG. 5, the rigid connection unit 13 could also be connected to the first flexible connection units 12 in a one-to-many way, i.e., one rigid connection unit 13 is connected to at least two first flexible connection units 12.

As another preferred embodiment, the way of "being connected by ACF bonding" according to the first embodiment could be replaced with the way of "being connected by metal-welding".

### Fourth Embodiment

The flat panel device further includes a second flexible connection unit, and the rigid connection unit could be further connected to the second flexible connection unit by ACF bonding. As illustrated in FIG. 11, the second flexible connection unit 14 includes a third wire 141 and a fifth conductive contact terminal 142 and a sixth conductive contact terminal 143 which are disposed at the two ends of the third wire 141; the fourth conductive contact terminal 133 of the rigid connection unit 13 is connected to the fifth conductive contact terminal 142 of the second flexible connection unit 14 by ACF bonding. Optionally, the second flexible connection unit is a FPC.

The second flexible connection unit could be connected to the chip unit by ACF bonding. As illustrated in FIG. 12, the sixth conductive contact terminal 143 of the second flexible connection unit 14 is connected to the chip unit 15 by ACF bonding. Specifically, the sixth conductive contact terminal 143 of the second flexible connection unit 14 is connected to a chip conductive contact terminal 152 of the chip unit 15 by ACF bonding.

As illustrated in FIG. 7, the rigid connection unit 13 could be connected to the second flexible connection unit 14 in a one-to-one way, i.e., one rigid connection unit 13 is connected to one second flexible connection unit 14. As illustrated in FIG. 8, the rigid connection unit 13 may also be connected to the second flexible connection units 14 in a one-to-many way, i.e., one rigid connection unit 13 is connected to at least two second flexible connection units 14.

As another preferred embodiment, the way of "being connected by ACF bonding" according to the first embodiment could be replaced with the way of "being connected by metal-welding".

### Fifth Embodiment

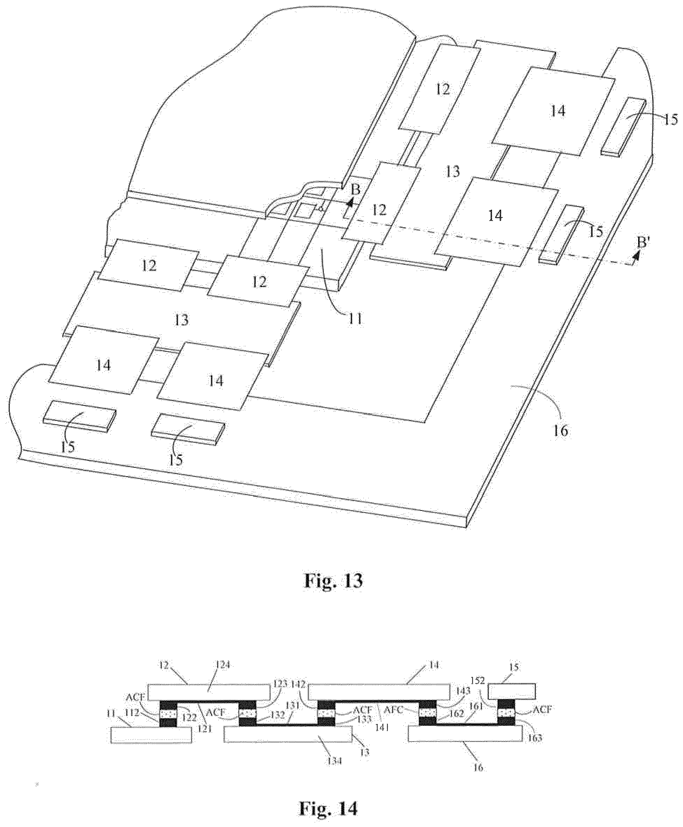

As illustrated in FIG. 13, the flat panel device further includes a PCB 16; the second flexible connection unit 14 is connected to the PCB 16; the PCB 16 is connected to the chip unit 15 by ACF bonding. As illustrated in FIG. 14, the PCB 16 includes a fourth wire 161, and a seventh conductive contact terminal 162 and a eighth conductive contact terminal 163 which are disposed at the two ends of the fourth wire respectively; the sixth conductive contact terminal 143 of the second flexible connection unit 14 is connected to the seventh conductive contact terminal 162 of the PCB by ACF bonding; the eighth conductive contact terminal 163 of the PCB is connected to a chip conductive contact terminal 152 of the chip unit 15 by ACF bonding. It is to be understood that the second flexible connection unit 14 could be connected to the PCB 16 by other ways such as a connector.

On the PCB, a circuit unit could be disposed, and the circuit unit includes a peripheral logic control and image processing system.

As another preferred embodiment, the way of "being connected by ACF bonding" according to the first embodiment could be replaced with the way of "being connected by metal-welding".

### Sixth Embodiment

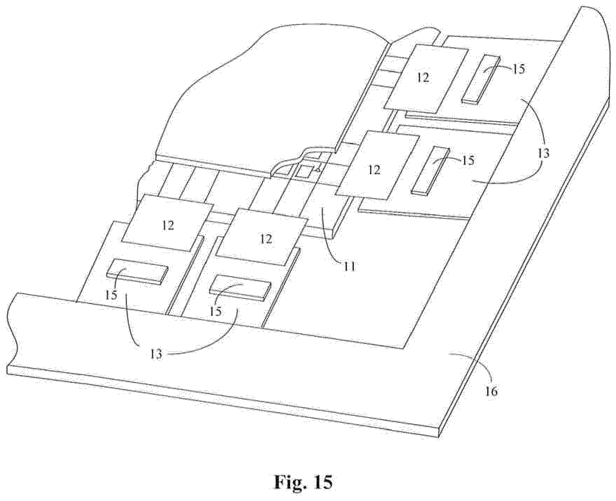

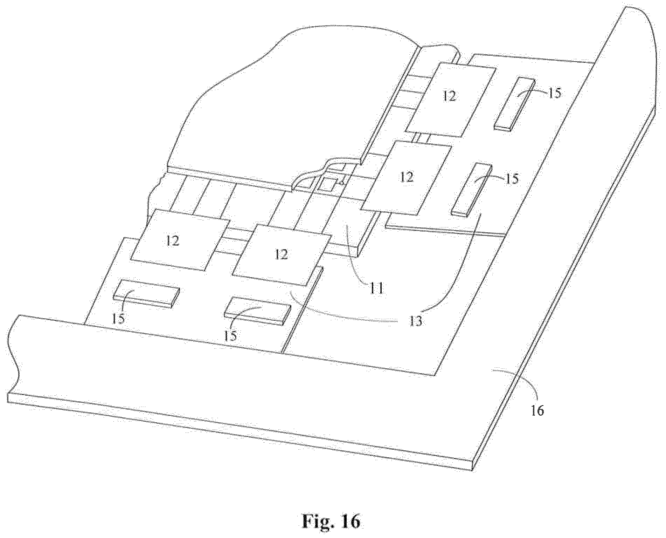

As illustrated in FIG. 15 and 16, on the basis of the third embodiment, the flat panel device further includes a PCB 16; the PCB 16 is connected to a rigid connection unit 13 and is electrically connected to a chip unit 15 via a second wire 131.

### Seventh Embodiment

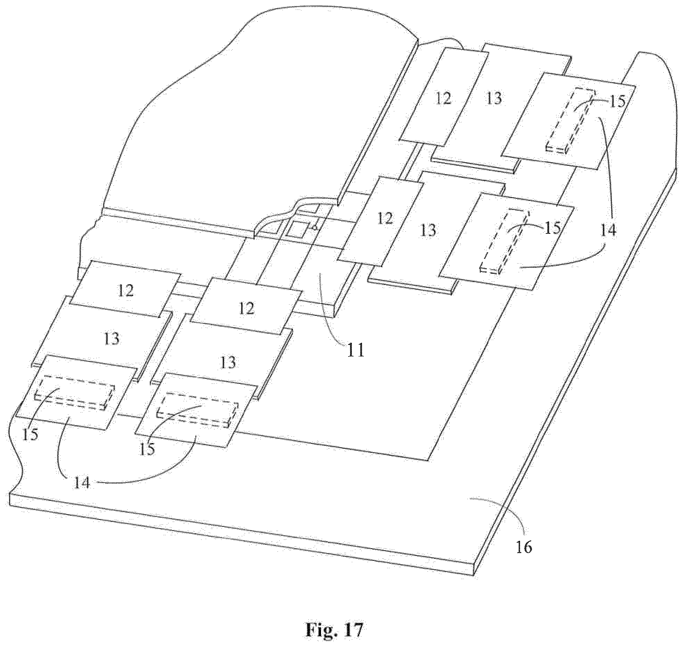

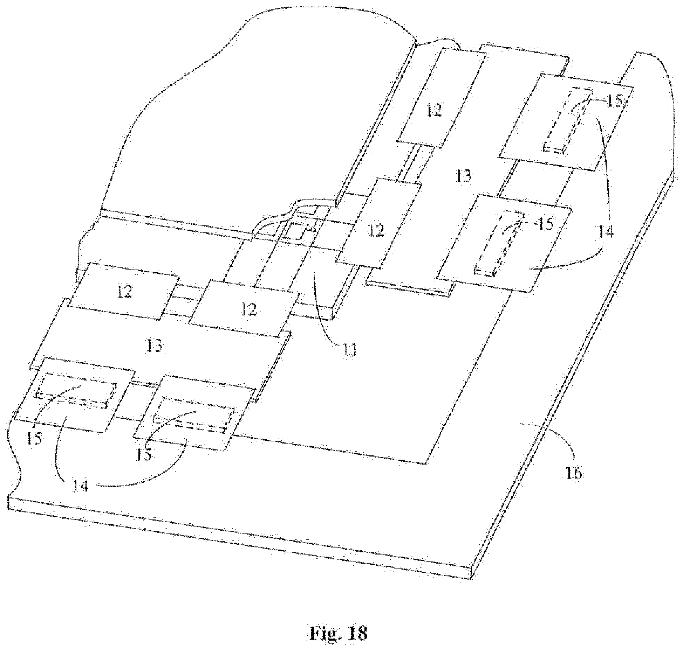

As illustrated in FIG. 17 and 18, on the basis of the fourth embodiment, the flat panel device further includes a PCB 16; the PCB 16 is connected to a second flexible connection unit 14 and is electrically connected to a chip unit 15 via a third wire 141.

In an embodiment, the substrate unit may include a TFT array substrate. The TFT array substrate could be a TFT array substrate for a flat panel apparatus, for example, a TFT array substrate for a liquid crystal display(LCD), a TFT array substrate for an electronic paper, a TFT array substrate for an active matrix/organic light emitting diode (AMOLED), and a TFT array substrate for a X-ray flat panel image sensor. The TFT array substrate includes a substrate and a layer of TFT array on the substrate. The layer of TFT array may include a plurality of scanning lines and multiple data lines crossed with each other. The region surrounded by the adjacent scanning lines and adjacent data lines is a pixel region. In the pixel region, a plurality of pixel electrodes are disposed. At the intersection of the scanning line and the data line there is disposed a TFT switch. The pixel electrode is coupled to the scanning line and the data line via the TFT switch, i.e., a gate electrode of the TFT is electrically connected to the corresponding scanning line, and a source electrode/drain electrode of the TFT is electrically connected to the corresponding data line, a drain electrode/source electrode of the TFT is electrically connected to the corresponding pixel electrode. For the AMOLED, on the pixel electrodes, the organic light emitting diodes are disposed. For the X-ray flat panel image sensor, on the pixel electrodes, a photosensitive sensor is disposed, which generally is a photosensitive diode.

In another embodiment, the substrate unit could be a touch screen. The touch screen could be a capacitive touch screen, a resistance-type touch screen or the like. The touch screen includes a substrate and a touch layer on the substrate. Taking the capacitive touch screen as an example, the touch layer includes a plurality of scanning lines and multiple sensing lines crossed with each other. At the intersection of the scanning lines and the sensing lines, an insulating layer is disposed.

A flat panel image sensor is further provided according to an embodiment of the present invention, including the flat panel device containing the TFT array substrate according to the above-mentioned embodiment. In the pixel regions of the TFT array substrate, the photosensitive sensors are disposed.

An AMOLED is further provided according to an embodiment of the present invention, including the flat panel device containing the TFT array substrate according to the above-mentioned embodiment. In the pixel regions of the TFT array substrate, organic light-emitting diodes are disposed.

A liquid crystal display is further provided according to an embodiment of the present invention, including: the flat panel device containing the TFT array substrate according to the above-mentioned embodiment, a color film substrate, and a liquid crystal layer. In the pixel regions of the TFT array substrate, the pixel electrodes are disposed; the color film substrate and the TFT array substrate are disposed opposite to each other, with the liquid crystal layer filling between the color film substrate and the TFT array substrate.

An electronic paper display is further provided according to an embodiment of the present invention, including: the flat panel device containing the TFT array substrate according to the above-mentioned embodiment, an upper substrate and a microcapsule layer. In the pixel regions of the TFT array substrate, the pixel electrodes are disposed; the upper substrate and the TFT array substrate are disposed opposite to each other, with the microcapsule layer filling between the upper substrate and the TFT array substrate.

A touch apparatus is further provided according to an embodiment of the present invention, including the flat panel device according to the above-mentioned embodiment, in which a touch screen serves as the substrate unit.

Though the present invention is disclosed by way of preferred embodiments as described above, the present invention is not limited thereto. Various variations and changes may be made by any skilled in the art without departing from the scope of the present invention. Therefore, the scope of protection of the present invention should be defined by the claims.

## Claims

1. A connecting device for connecting a substrate unit (11) and a chip unit (15), the connecting device comprising:
a first flexible connection unit (12), comprising a first wire (121) for electrically connecting to the substrate unit (11); and
a rigid connection unit (13), connected to the first flexible connection unit (12) and comprising a second wire (131) for electrically connecting to the first wire (121);
wherein the chip unit (15) is electrically connected to the second wire (131);
a first conductive contact terminal (122) and a second conductive contact terminal (123) are disposed on two ends of the first wire (121) of the first flexible connection unit (12), respectively; a third conductive contact terminal (132) is disposed on one end of the second wire (131) of the rigid connection unit (13); the first conductive contact terminal (122) is used for connecting to the substrate unit (11) by anisotropic conductive film bonding or metal-welding; and the second conductive contact terminal (123) and the third conductive contact terminal (132) are connected by anisotropic conductive film bonding or metal-welding;
the rigid connection unit (13) further comprises a rigid substrate (134); a fourth conductive contact terminal (133) is disposed on the other end of the second wire (131) of the rigid connection unit (13); and the second wire (131), the third conductive contact terminal (132) and the fourth conductive contact terminal (133) are disposed on the rigid substrate (134);
**characterized in that**
the connecting device further comprises a second flexible connection unit (14), wherein the second flexible connection unit (14) comprises a fifth conductive contact terminal (142), a sixth conductive contact terminal (143) and a third wire (141) connecting the fifth conductive contact terminal (142) and sixth conductive contact terminal (143); the fourth conductive contact terminal (133) and the fifth conductive contact terminal (142) are connected by anisotropic conductive film bonding or metal-welding; the sixth conductive contact terminal (143) is used for connecting to the chip unit (15) by anisotropic conductive film bonding or metal-welding..

2. A flat panel device, comprising: a substrate unit (11), a first flexible connection unit (12), a rigid connection unit (13) and a chip unit (15), wherein
the first flexible connection unit (12), connected to the substrate unit (11), comprises a first wire (121) electrically connected to the substrate unit (11);
the rigid connection unit (13), connected to the first flexible connection unit (12), comprises a second wire (131) electrically connected to the first wire (121); and
the chip unit (15) is electrically connected to the substrate unit (11) via the second wire (131) and the first wire (121) in sequence;
the substrate unit (11) and the first flexible connection unit (12) are connected by anisotropic conductive film bonding or metal-welding; and the first flexible connection unit (12) and the rigid connection unit (13) are connected by anisotropic conductive film bonding or metal-welding;
**characterized in that**
the flat panel device further comprises a second flexible connection unit (14), wherein the rigid connection unit (13) and the second flexible connection unit (14) are connected by anisotropic conductive film bonding or metal-welding.

3. The flat panel device according to claim 2, wherein the second flexible connection unit (14) and the chip unit (15) are connected by anisotropic conductive film bonding or metal-welding.

4. The flat panel device according to claim 2, further comprising a printed circuit board (16), wherein the second flexible connection unit (14) is connected to the printed circuit board (16), and the printed circuit board (16) is connected to the chip unit (15) by anisotropic conductive film bonding or metal-welding.

5. The flat panel device according to claim 2, wherein the substrate unit (11) comprises a substrate conductive contact terminal (112); a first conductive contact terminal (122) and a second conductive contact terminal (123) are disposed on two ends of the first wire (121) of the first flexible connection unit (12), respectively; a third conductive contact terminal (132) and a fourth conductive contact terminal (133) are disposed on two ends of the second wire (131) of the rigid connection unit (13), respectively; the substrate conductive contact terminal (112) and the first conductive contact terminal (122) are connected by anisotropic conductive film bonding or metal-welding; the second conductive contact terminal (123) and the third conductive contact terminal (132) are connected by anisotropic conductive film bonding or metal-welding.

6. The flat panel device according to claim 5, wherein the fourth conductive contact terminal (133) of the rigid connection unit (13) and the chip unit (15) are connected by anisotropic conductive film bonding or metal-welding.

7. The flat panel device according to claim 5, further comprising a printed circuit board (16), wherein the printed circuit board (16) comprises a fourth wire (161), a seventh conductive contact terminal (162) and an eighth conductive contact terminal (163) respectively disposed at two ends of the fourth wire (161); the sixth conductive contact terminal (143) of the second flexible connection unit (14) is connected to the printed circuit board (16); and the printed circuit board (16) is connected to the chip unit (15) by anisotropic conductive film bonding or metal-welding.

8. The flat panel device according to claim 2, wherein the substrate unit (11) comprises a thin film transistor, TFT, array substrate.

9. A liquid crystal display, comprising a color film substrate, a liquid crystal layer and the flat panel device according to claim 8, wherein, in a pixel region of the TFT array substrate, a plurality of pixel electrodes are disposed; the color film substrate and the TFT array substrate are disposed opposite to each other, with the liquid crystal layer filled between the color film substrate and the TFT array substrate.

## Patentansprüche

1. Verbindungsvorrichtung zum Verbinden einer Substrateinheit (11) und einer Chipeinheit (15), wobei die Verbindungsvorrichtung Folgendes umfasst:
eine erste flexible Verbindungseinheit (12), umfassend einen ersten Draht (121) zum elektrischen Verbinden mit der Substrateinheit (11); und
eine starre Verbindungseinheit (13), verbunden mit der ersten flexiblen Verbindungseinheit (12) und umfassend einen zweiten Draht (131) zum elektrischen Verbinden mit dem ersten Draht (121);
wobei die Chipeinheit (15) elektrisch mit dem zweiten Draht (131) verbunden ist;
ein erster leitender Kontaktanschluss (122) und ein zweiter leitender Kontaktanschluss (123) sind an einem Ende, bzw. am anderen Ende, des ersten Drahts (121) der ersten flexiblen Verbindungseinheit (12) angeordnet; ein dritter leitender Kontaktanschluss (132) ist an einem Ende des zweiten Drahts (131) der starren Verbindungseinheit (13) angeordnet; der erste leitende Kontaktanschluss (122) wird zum Verbinden mit der Substrateinheit (11) durch Kleben mit einer anisotropen leitenden Schicht oder durch Metallschweißen verwendet; und der zweite leitende Kontaktanschluss (123) und der dritte leitende Kontaktanschluss (132) sind durch Kleben mit einer anisotropen leitenden Schicht oder durch Metallschweißen verbunden;
die starre Verbindungseinheit (13) umfasst weiterhin ein starres Substrat (134); ein vierter leitender Kontaktanschluss (133) ist am anderen Ende des zweiten Drahts (131) der starren Verbindungseinheit (13) angeordnet; und der zweite Draht (131), der dritte leitende Kontaktanschluss (132) und der vierte leitende Kontaktanschluss (133) sind auf dem starren Substrat (134) angeordnet;
**dadurch gekennzeichnet, dass**
die Verbindungsvorrichtung weiterhin eine zweite flexible Verbindungseinheit (14) umfasst, wobei die zweite flexible Verbindungseinheit (14) einen fünften leitenden Kontaktanschluss (142), einen sechsten leitenden Kontaktanschluss (143) und einen dritten Draht (141) umfasst, der den fünften leitenden Kontaktanschluss (142) und den sechsten leitenden Kontaktanschluss (143) verbindet; der vierte leitende Kontaktanschluss (133) und der fünfte leitende Kontaktanschluss (142) sind durch Kleben mit einer anisotropen leitenden Schicht oder durch Metallschweißen verbunden; der sechste leitende Kontaktanschluss (143) wird zum Verbinden mit der Chipeinheit (15) durch Kleben mit einer anisotropen leitenden Schicht oder durch Metallschweißen verwendet.

2. Ein flaches Panelgerät, umfassend: eine Substrateinheit (11), eine erste flexible Verbindungseinheit (12), eine starre Verbindungseinheit (13) und eine Chipeinheit (15), wobei
die erste flexible Verbindungseinheit (12), verbunden mit der Substrateinheit (11), einen ersten Draht (121) umfasst, der elektrisch mit der Substrateinheit (11) verbunden ist;
die starre Verbindungseinheit (13), die mit der ersten flexiblen Verbindungseinheit (12) verbunden ist, einen zweiten Draht (131) umfasst, der elektrisch mit dem ersten Draht (121) verbunden ist; und
die Chipeinheit (15) über den zweiten Draht (131) und anschließend über den ersten Draht (121) elektrisch mit der Substrateinheit (11) verbunden ist;
die Substrateinheit (11) und die erste flexible Verbindungseinheit (12) sind durch Kleben mit einer anisotropen leitenden Schicht oder durch Metallschweißen verbunden; und die erste flexible Verbindungseinheit (12) und die starre Verbindungseinheit (13) sind durch Kleben mit einer anisotropen leitenden Schicht oder durch Metallschweißen verbunden;
**dadurch gekennzeichnet, dass**
das flache Panelgerät weiterhin eine zweite flexible Verbindungseinheit (14) umfasst, wobei die starre Verbindungseinheit (13) und die zweite flexible Verbindungseinheit (14) durch Kleben mit einer anisotropen leitenden Schicht oder durch Metallschweißen verbunden sind.

3. Das flache Panelgerät nach Anspruch 2, wobei die zweite flexible Verbindungseinheit (14) und die Chipeinheit (15) durch Kleben mit einer anisotropen leitenden Schicht oder durch Metallschweißen verbunden sind.

4. Das flache Panelgerät nach Anspruch 2, weiterhin umfassend eine gedruckte Schaltungsplatine (16), wobei die zweite flexible Verbindungseinheit (14) mit der gedruckten Schaltungsplatine (16) verbunden ist, und wobei die gedruckte Schaltungsplatine (16) durch Kleben mit einer anisotropen leitenden Schicht oder durch Metallschweißen mit der Chipeinheit (15) verbunden ist.

5. Das flache Panelgerät nach Anspruch 2, wobei die Substrateinheit (11) einen leitenden Kontaktanschluss (112) des Substrats umfasst; ein erster leitender Kontaktanschluss (122) und ein zweiter leitender Kontaktanschluss (123) sind an einem Ende, bzw. am anderen Ende, des ersten Drahts (121) der ersten flexiblen Verbindungseinheit (12) angeordnet; ein dritter leitender Kontaktanschluss (132) und ein vierter leitender Kontaktanschluss (133) sind an einem Ende, bzw. am anderen Ende, des zweiten Drahts (131) der starren Verbindungseinheit (13) angeordnet; der leitende Kontaktanschluss (112) des Substrats und der erste leitende Kontaktanschluss (122) sind durch Kleben mit einer anisotropen leitenden Schicht oder durch Metallschweißen verbunden; der zweite leitende Kontaktanschluss (123) und der dritte leitende Kontaktanschluss (132) sind durch Kleben mit einer anisotropen leitenden Schicht oder durch Metallschweißen verbunden.

6. Das flache Panelgerät nach Anspruch 5, wobei der vierte leitende Kontaktanschluss (133) der starren Verbindungseinheit (13) und die Chipeinheit (15) durch Kleben mit einer anisotropen leitenden Schicht oder durch Metallschweißen verbunden sind.

7. Das flache Panelgerät nach Anspruch 5, weiterhin umfassend eine gedruckte Schaltungsplatine (16), wobei die gedruckte Schaltungsplatine (16) einen vierten Draht (161) sowie einen siebten leitenden Kontaktanschluss (162) und einen achten leitenden Kontaktanschluss (163) umfasst, die an einem Ende bzw. am anderen Ende des vierten Drahts (161) angeordnet sind; der sechste leitende Kontaktanschluss (143) der zweiten flexiblen Verbindungseinheit (14) ist mit der gedruckten Schaltungsplatine (16) verbunden; und die gedruckte Schaltungsplatine (16) ist durch Kleben mit einer anisotropen leitenden Schicht oder durch Metallschweißen mit der Chipeinheit (15) verbunden.

8. Das flache Panelgerät nach Anspruch 2, wobei die Substrateinheit (11) ein Substrat mit einer Matrix von Dünnschichttransistoren, TFT, umfasst.

9. Eine Flüssigkristallanzeige, umfassend ein Farbschichtsubstrat, eine Flüssigkristallschicht und das flache Panelgerät nach Anspruch 8, wobei in einer Pixelregion des Substrats mit der Matrix von TFT eine Mehrzahl von Pixelelektroden angeordnet ist; das Farbschichtsubstrat und das Substrat mit der Matrix von TFT sind einander gegenüberliegend angeordnet, wobei die Flüssigkristallschicht zwischen das Farbschichtsubstrat und das Substrat mit der Matrix von TFT gefüllt ist.

## Revendications

1. Un dispositif de connexion pour connecter une unité formant substrat (11) et une unité formant puce (15), le dispositif de connexion comprenant :
une première unité de connexion flexible (12), comprenant un premier fil (121) pour une connexion électrique à l'unité formant substrat (11) ; et
une unité de connexion rigide (13), reliée à la première unité de connexion flexible (12) et comprenant un deuxième fil (131) pour une connexion électrique au premier fil (121) ;
l'unité formant puce (15) étant connectée électriquement au deuxième fil (131) ;
une première borne de contact conductrice (122) et une deuxième borne de contact conductrice (123) sont disposées sur deux extrémités du premier fil (121) de la première unité de connexion flexible (12), respectivement ; une troisième borne de contact conductrice (132) est disposée sur une extrémité du deuxième fil (131) de l'unité de connexion rigide (13) ; la première borne de contact conductrice (122) est utilisée pour la connexion à l'unité formant substrat (11) par une liaison par un film conducteur anisotrope ou par un soudage par un métal ; et la deuxième borne de contact conductrice (123) et la troisième borne de contact conductrice (132) sont connectées par une liaison par un film conducteur anisotrope ou une par un soudage par un métal ;
l'unité de connexion rigide (13) comprend en outre un substrat rigide (134) ; une quatrième borne de contact conductrice (133) est disposée sur l'autre extrémité du deuxième fil (131) de l'unité de connexion rigide (13) ; et le deuxième fil (131), la troisième borne de contact conductrice (132) et la quatrième borne de contact conductrice (133) sont disposés sur le substrat rigide (134) ;
**caractérisé en ce que**
le dispositif de connexion comprend en outre une deuxième unité de connexion flexible (14), la deuxième unité de connexion flexible (14) comprenant une cinquième borne de contact conductrice (142), une sixième borne de contact conductrice (143) et un troisième fil (141) connectant la cinquième borne de contact conductrice (142) et la sixième borne de contact conductrice (143) ; la quatrième borne de contact conductrice (133) et la cinquième borne de contact conductrice (142) sont connectées par une liaison par un film conducteur anisotrope ou par un soudage par un métal ; la sixième borne de contact conductrice (143) est utilisée pour la connexion à l'unité formant puce (15) par une liaison par un film conducteur anisotrope ou par un soudage par un métal.

2. Un dispositif à panneau plat, comprenant : une unité formant substrat (11), une première unité de connexion flexible (12), une unité de connexion rigide (13) et une unité formant puce (15), dans lequel
la première unité de connexion flexible (12), connectée à l'unité formant substrat (11), comprend un premier fil (121) connecté électriquement à l'unité formant substrat (11) ;
l'unité de connexion rigide (13), connectée à la première unité de connexion flexible (12), comprend un deuxième fil (131) connecté électriquement au premier fil (121) ; et
l'unité formant puce (15) est connectée électriquement à l'unité formant substrat (11) via le deuxième fil (131) et le premier fil (121) en séquence ;
l'unité formant substrat (11) et la première unité de connexion flexible (12) sont connectées par une liaison par un film conducteur anisotrope ou par un soudage par un métal ; et la première unité de connexion flexible (12) et l'unité de connexion rigide (13) sont connectées par une liaison par un film conducteur anisotrope ou par un soudage par un métal ;
**caractérisé en ce que**
le dispositif à panneau plat comprend en outre une deuxième unité de connexion flexible (14), dans laquelle l'unité de connexion rigide (13) et la deuxième unité de connexion flexible (14) sont connectées par une liaison par un film conducteur anisotrope ou par un soudage par un métal.

3. Le dispositif à panneau plat selon la revendication 2, dans lequel la deuxième unité de connexion flexible (14) et l'unité formant puce (15) sont connectées par une liaison par un film conducteur anisotrope ou par un soudage par un métal.

4. Le dispositif à panneau plat selon la revendication 2, comprenant en outre une carte à circuit imprimé (16), la deuxième unité de connexion flexible (14) étant connectée à la carte à circuit imprimé (16), et la carte à circuit imprimé (16) étant connectée à l'unité formant puce (15) par une liaison par un film conducteur anisotrope ou par un soudage par un métal.

5. Le dispositif à panneau plat selon la revendication 2, dans lequel l'unité formant substrat (11) comprend une borne de contact (112) conductrice de substrat ; une première borne de contact conductrice (122) et une deuxième borne de contact conductrice (123) sont disposées sur deux extrémités du premier fil (121) de la première unité de connexion flexible (12), respectivement ; une troisième borne de contact conductrice (132) et une quatrième borne de contact conductrice (133) sont disposées sur deux extrémités du deuxième fil (131) de l'unité de connexion rigide (13), respectivement; la borne de contact (112) conductrice de substrat et la première borne de contact conductrice (122) sont connectées par une liaison par un film conducteur anisotrope ou par un soudage par un métal ; la deuxième borne de contact conductrice (123) et la troisième borne de contact conductrice (132) sont connectées par une liaison par un film conducteur anisotrope ou par un soudage par un métal.

6. Le dispositif à panneau plat selon la revendication 5, dans lequel la quatrième borne de contact conductrice (133) de l'unité de connexion rigide (13) et l'unité formant puce (15) sont connectées par une liaison par un film conducteur anisotrope ou par un soudage par un métal.

7. Le dispositif à panneau plat selon la revendication 5, comprenant en outre une carte à circuit imprimé (16), la carte à circuit imprimé (16) comprenant un quatrième fil (161), une septième borne de contact conductrice (162) et une huitième borne de contact conductrice (163) disposées respectivement à deux extrémités du quatrième fil (161) ; la sixième borne de contact conductrice (143) de la deuxième unité de connexion flexible (14) est connectée à la carte à circuit imprimé (16) ; et la carte à circuit imprimé (16) est connectée à l'unité formant puce (15) par une liaison par un film conducteur anisotrope ou par un soudage par un métal.

8. Le dispositif à panneau plat selon la revendication 2, dans lequel l'unité formant substrat (11) comprend un substrat formant réseau à transistor à couches minces, TFT.

9. Un afficheur à cristaux liquides, comprenant un substrat formant film couleur, une couche de cristaux liquides et le dispositif à panneau plat selon la revendication 8, dans lequel, dans une zone de pixels du substrat formant réseau TFT, des électrodes de pixel faisant partie d'une pluralité d'électrodes de pixel sont disposés ; le substrat formant film couleur et le substrat en réseau TFT sont disposés de façon opposée l'un à l'autre, avec la couche de cristaux liquides remplie entre le substrat formant film couleur et le substrat en réseau TFT.
